# EUROPÄISCHE PATENTANMELDUNG

(11) **EP 4 360 879 A2**
(43) Veröffentlichungstag der Anmeldung: **01.05.2024**
(21) Anmeldenummer: 24163131.6
(22) Anmeldetag: 05.07.2017
(51) Int. Cl.: B33Y 40/00

(54) **ANLAGE ZUR ADDITIVEN HERSTELLUNG DREIDIMENSIONALER OBJEKTE**

(30) Priorität: 19.12.2016 DE 102016124876
(62) Teilanmeldung aus: 20191298.7
(71) Anmelder: Concept Laser GmbH, 96215 Lichtenfels (DE)
(72) Erfinder: HOFMANN, Alexander, 96215 Lichtenfels (DE); STAMMBERGER, Jens, 96215 Lichtenfels (DE); BRÜCKNER, Patrick, 96215 Lichtenfels (DE)
(74) Vertreter: Hafner & Kohl PartmbB

(57) **Zusammenfassung**

Anlage (1) zur additiven Herstellung dreidimensionaler Objekte, umfassend wenigstens eine Arbeitsstation (2), welche zur Durchführung wenigstens eines Arbeitsvorgangs im Rahmen der additiven Herstellung dreidimensionaler Objekte eingerichtet ist, umfassend: wenigstens einen, insbesondere benutzerseitig, bewegbaren, insbesondere verschiebbaren, Transportwagen (5), welcher eine Rahmenkonstruktion (6) umfasst, welche eine Aufnahmeeinrichtung (8) umfasst, welche einen zur Aufnahme eines Pulvermoduls (4) innerhalb der Rahmenkonstruktion (6) eingerichteten Aufnahmeraum (8a) umfasst, wobei die Rahmenkonstruktion (6) wenigstens zwei Rahmenkonstruktionsabschnitte (6a, 6b) umfasst, wobei ein erster Rahmenkonstruktionsabschnitt (6a) bewegbar relativ zu einem zweiten Rahmenkonstruktionsabschnitt (6b), insbesondere in einer vertikal ausgerichteten Bewegungsrichtung, gelagert ist, wobei der Transportwagen (5) wenigstens eine, insbesondere motorische, Hubeinrichtung (7) umfasst, welche zur Erzeugung einer den ersten Rahmenkonstruktionsabschnitt (6a) in eine Bewegung relativ zu dem zweiten Rahmenkonstruktionsabschnitt (6b) versetzenden Hubkraft eingerichtet ist.

## Beschreibung

Die Erfindung betrifft eine Anlage zur additiven Herstellung dreidimensionaler Objekte, umfassend wenigstens eine Arbeitsstation, welche zur Durchführung wenigstens eines Arbeitsvorgangs im Rahmen der additiven Herstellung dreidimensionaler Objekte eingerichtet ist.

Anlagen zur additiven Herstellung dreidimensionaler Objekte sind dem Grunde nach bekannt. Entsprechende Anlagen umfassen typischerweise eine oder mehrere Arbeitsstationen, welche jeweils zur Durchführung wenigstens eines Arbeitsvorgangs im Rahmen der additiven Herstellung dreidimensionaler Objekte eingerichtet sind.

Es ist bekannt, Pulvermodule, wie z. B. Baumodule, welche einen Bauraum begrenzen, in welchem der eigentliche additive Aufbau dreidimensionaler Objekte erfolgt, zwischen verschiedenen Arbeitsstationen einer Anlage zu befördern. Zur Beförderung entsprechender Pulvermodule wurden Transportwagen vorgeschlagen, welche über eine Aufnahmemöglichkeit zur Aufnahme eines zu befördernden Pulvermoduls verfügen.

Um in entsprechenden transportwagenseitigen Aufnahmemöglichkeiten aufgenommene Pulvermodule von einem entsprechenden Pulvermodul an bzw. in eine entsprechende Arbeitsstation, oder umgekehrt, zu übergeben, sind die Transportwagen an jeweilige arbeitsstationseitige Gehäusekonstruktionen anzudocken. Die Andockvorgänge jeweiliger Transportwagen an jeweilige arbeitsstationseitige Gehäusekonstruktionen sind bisweilen aufwändig.

Zudem ist die Handhabung der Transportwagen, insbesondere im mit einem Pulvermodul "beladenen" Zustand, bisweilen verbesserungswürdig, was auf einen vergleichsweise hohen Schwerpunkt der Transportwagen in deren mit einem Pulvermodul "beladenden" Zustand im Vergleich zu deren "unbeladenem" Zustand zurückzuführen ist.

Der Erfindung liegt die Aufgabe zugrunde, eine verbesserte Anlage zur additiven Herstellung dreidimensionaler Objekte anzugeben, welche sich insbesondere durch verbesserte Transportwagen auszeichnet.

Die Aufgabe wird durch eine Anlage gemäß Anspruch 1 gelöst. Die hierzu abhängigen Ansprüche betreffen mögliche Ausführungsformen der Anlage.

Die hierin beschriebene Anlage ("Anlage") dient zur additiven Herstellung dreidimensionaler Objekte, d. h. beispielsweise technischer Bauteile bzw. technischer Bauteilgruppen. Die Anlage umfasst mehrere Arbeitsstationen, welche jeweils zur Durchführung wenigstens eines Arbeitsvorgangs im Rahmen der additiven Herstellung dreidimensionaler Objekte ("Objekte") eingerichtet sind. Entsprechende Arbeitsvorgänge im Rahmen der additiven Herstellung eines Objekts betreffen einerseits additive Arbeitsvorgänge, d. h. additive Bauvorgänge, in welchen tatsächlich ein additiver Aufbau eines Objekts, insbesondere durch sukzessive schichtweise selektive Belichtung und damit einhergehende sukzessive schichtweise selektive Verfestigung von Baumaterialschichten aus einem verfestigbaren Baumaterial vermittels eines Energiestrahls erfolgt, erfolgen, sowie vor jeweiligen additiven Arbeits- bzw. Bauvorgängen durchzuführende bzw. durchgeführte vorbereitende Arbeitsvorgänge, d. h. z. B. Reinigungs-, Inertisierungs- und Temperierungsvorgänge von Pulvermodulen, sowie nach jeweiligen additiven Arbeits- bzw. Bauvorgängen durchzuführende bzw. durchgeführte nachbereitende Arbeitsvorgänge, d. h. z. B. Auspackvorgänge additiv hergestellter Objekte aus entsprechenden Pulvermodulen.

Eine zur Durchführung additiver Arbeitsvorgänge eingerichtete, auch als Prozesstation zu bezeichnende erste Arbeitsstation kann als eine Vorrichtung ("Vorrichtung") zur additiven Herstellung von Objekten ausgebildet sein oder eine solche umfassen. Eine entsprechende Vorrichtung ist zur additiven Herstellung von Objekten, d. h. beispielsweise technischer Bauteile bzw. technischer Bauteilgruppen, durch sukzessive schichtweise selektive Belichtung und damit einhergehende sukzessive schichtweise selektive Verfestigung von Baumaterialschichten aus einem verfestigbaren Baumaterial eingerichtet. Bei dem Baumaterial kann es sich um ein partikuläres bzw. pulverförmiges Metall-, Kunststoff- und/oder Keramikmaterial handeln. Die selektive Verfestigung jeweiliger selektiv zu verfestigender Baumaterialschichten erfolgt auf Grundlage objektbezogener Baudaten. Entsprechende Baudaten beschreiben die geometrischkonstruktive Gestalt des jeweils additiv herzustellenden Objekts und können beispielsweise "geslicte" CAD-Daten des additiv herzustellenden Objekts beinhalten. Die Vorrichtung kann z. B. als SLM-Vorrichtung, d. h. als Vorrichtung zur Durchführung selektiver Laserschmelzverfahren (SLM-Verfahren), oder als SLS-Vorrichtung, d. h. als Vorrichtung zur Durchführung selektiver Lasersinterverfahren (SLS-Verfahren), ausgebildet sein.

Eine entsprechende Vorrichtung umfasst die zur Durchführung additiver Bauvorgänge typischerweise erforderlichen Funktionskomponenten. Hierzu zählen insbesondere eine Beschichtungseinrichtung, welche zur Ausbildung selektiv zu verfestigender Baumaterialschichten (in der Bauebene der Vorrichtung) eingerichtet ist, und eine Belichtungseinrichtung, welche zur selektiven Belichtung selektiv zu verfestigender Baumaterialschichten (in der Bauebene der Vorrichtung) eingerichtet ist. Die Beschichtungseinrichtung umfasst typischerweise mehrere Bestandteile, d. h. z. B. ein ein, insbesondere klingenförmiges, Beschichtungswerkzeug umfassendes Beschichtungselement sowie eine Führungseinrichtung zur Führung des Beschichtungselements entlang einer definierten Bewegungsbahn. Auch die Belichtungseinrichtung umfasst typischerweise mehrere Bestandteile, d. h. z. B. eine Strahlerzeugungseinrichtung zur Erzeugung eines Energie- bzw. Laserstrahls, eine Strahlablenkeinrichtung (Scannereinrichtung) zur Ablenkung eines von der Strahlerzeugungseinrichtung erzeugten Energie- bzw. Laserstrahls auf einen zu belichtenden Bereich einer selektiv zu verfestigenden Baumaterialschicht sowie diverse optische Elemente, wie z. B. Linsenelemente, Objektivelemente, etc. Die genannten Funktionskomponenten der Vorrichtung sind typischerweise an oder in einer, typischerweise inertisierbaren, Prozesskammer der Vorrichtung angeordnet oder ausgebildet.

Eine zur Durchführung nachbereitender Arbeitsvorgänge eingerichtete, auch als Nachbearbeitungsstation zu bezeichnende, optionale weitere (bzw. zweite) Arbeitsstation kann als eine Vorrichtung zum Auspacken eines additiv hergestellten Objekts ausgebildet sein oder eine solche umfassen. Die Vorrichtung kann zum Auspacken eines additiv hergestellten Objekts durch Entfernen des das additive hergestellte Objekte umgebenden, typischerweise nicht verfestigten, Baumaterials eingerichtet sein. Eine entsprechende Vorrichtung umfasst die zum Entfernen des das additive hergestellte Objekte umgebenden, typischerweise nicht verfestigten, Baumaterials erforderlichen Funktionskomponenten. Hierzu zählt insbesondere eine Saug- und/oder Gebläseeinrichtung, welche zur Erzeugung einer Saug- und/oder Gebläseströmung eingerichtet ist, vermittels welcher das zu entfernende Baumaterial abgesaugt oder abgeblasen werden kann.

Eine zur Durchführung vorbereitender Arbeitsvorgänge eingerichtete, auch als Vorbereitungsstation zu bezeichnende, optionale weitere (bzw. dritte) Arbeitsstation kann als eine Vorrichtung zum Reinigen und/oder Inertisieren und/oder Temperieren von Pulvermodulen ausgebildet sein oder eine solche umfassen. Die Vorrichtung kann zum Reinigen und/oder Inertisieren und/oder Temperieren von Pulvermodulen eingerichtet sein. Eine entsprechende Vorrichtung umfasst die zum Reinigen und/oder Inertisieren und/oder Temperieren von Pulvermodulen erforderlichen Funktionskomponenten. Hierzu zählt insbesondere eine Reinigungseinrichtung, welche z. B. zur Erzeugung einer eine pulvermodulseitig umfasste Pulverkammer reinigenden Reinigungsströmung eingerichtet ist, bzw. eine Inertisierungseinrichtung, welche zur Erzeugung einer eine pulvermodulseitig umfasste Pulverkammer inertisierende Inertgasströmung eingerichtet ist, bzw. eine Temperiereinrichtung, welche zur Temperierung eines Pulvermoduls auf eine bestimmte Zieltemperatur eingerichtet ist.

Unabhängig von ihrer konkreten funktionellen Ausführung umfassen jeweilige Arbeitsstationen typischerweise eine eigene Gehäusekonstruktion, an oder in welcher die Funktionskomponenten der jeweiligen Arbeitsstation angeordnet oder ausgebildet sind. Die Arbeitsstationen sind sonach als gesonderte, durch jeweilige Gehäusekonstruktionen räumlich-körperlich definierte Funktionseinheiten der Anlage zu sehen, welche in diversen Konfigurationen relativ zueinander, z. B. in einem oder mehreren Gebäude(abschnitte)n, insbesondere Fabrikhallen, positionierbar sind.

Die Anlage umfasst typischerweise eine Mehrzahl an im Rahmen der additiven Herstellung dreidimensionaler Objekte verwendeter Pulvermodule. Ein jeweiliges Pulvermodul ist zur Aufnahme und/oder Abgabe von Baumaterial eingerichtet und umfasst hierfür typischerweise eine Pulverkammer. Die Pulverkammer begrenzt einen mit Baumaterial befüllbaren Pulverraum. Der Pulverraum ist zumindest seitlich durch Wandungen (Pulverkammerwandungen) der in der Regel hohlquaderartig bzw. hohlzylinderartig ausgebildeten Pulverkammer begrenzt. Bodenseitig kann der Pulverraum durch eine Trägereinrichtung begrenzt sein. Eine entsprechende Trägereinrichtung ist typischerweise zwischen zwei Endstellungen, d. h. zwischen einer (bezogen auf die Höhe des Pulvermoduls) oberen und einer unteren Endstellung, relativ zu der Pulverkammer bewegbar gelagert. Die bewegbare Lagerung der Trägereinrichtung ermöglicht die Realisierung einer, insbesondere linearen, Bewegung der Trägereinrichtung entlang einer vertikalen Bewegungsachse bzw. in einer vertikalen Bewegungsrichtung. Die bewegbare Lagerung der Trägereinrichtung ist typischerweise durch eine mit dieser gekoppelte, insbesondere (elektro)motorische, Antriebs- und/oder Aktoreinrichtung realisiert.

Konkret kann es sich bei einem Pulvermodul um ein Baumodul, in welchem der eigentliche additive Aufbau von Objekten erfolgt und welches hierfür im Rahmen der Durchführung additiver Bauvorgänge sukzessive schichtweise mit selektiv zu verfestigendem Baumaterial befüllt wird, oder um ein Dosiermodul, über welches im Rahmen der Durchführung additiver Bauvorgänge Baumaterial in die Prozesskammer dosiert wird, oder um ein Auffang- bzw. Überlaufmodul, welches im Rahmen der Durchführung additiver Bauvorgänge mit nicht verfestigtem Baumaterial befüllt wird, handeln.

Die Anlage umfasst weiter wenigstens einen Transportwagen - wenngleich im Weiteren zumeist von einem Transportwagen die Rede ist, umfasst die Anlage typischerweise mehrere entsprechende Transportwagen. Der Transportwagen ist benutzerseitig, d. h. durch aktives Bewegen durch einen Benutzer, und/oder (teil)automatisiert über eine integrierte, insbesondere (elektro)motorische, Antriebseinrichtung zwischen verschiedenen Arbeitsstation der Anlage bewegbar bzw. verfahrbar. Sofern transportwagenseitig vorhanden, umfasst eine entsprechende Antriebseinrichtung typischerweise wenigstens eine Kraftübertragungseinrichtung, welche zur Übertragung einer von der Antriebseinrichtung erzeugten Antriebskraft auf einen Untergrund eingerichtet ist. Die Kraftübertragungseinrichtung kann z. B. eine Anzahl an Rädern, Rollen, Ketten, etc. umfassen, über welche eine Übertragung der von der Antriebseinrichtung erzeugten Antriebskraft auf einen Untergrund realisierbar ist.

Der Transportwagen umfasst eine Rahmenkonstruktion. Die Rahmenkonstruktion umfasst wenigstens zwei Rahmenkonstruktionsabschnitte. Ein erster Rahmenkonstruktionsabschnitt ist, insbesondere in einer vertikal ausgerichteten Bewegungsachse bzw. -richtung, relativ zu einem zweiten Rahmenkonstruktionsabschnitt bewegbar gelagert. Wenngleich grundsätzlich denkbar, ist der zweite Rahmenkonstruktionsabschnitt typischerweise nicht bewegbar gelagert. Der erste Rahmenkonstruktionsabschnitt ist typischerweise oberhalb des zweiten Rahmenkonstruktionsabschnitts angeordnet oder ausgebildet. Zur Realisierung von Bewegungen des ersten Rahmenkonstruktionsabschnitts relativ zu dem zweiten Rahmenkonstruktionsabschnitt umfasst der Transportwagen wenigstens eine, insbesondere (elektro)motorische, Hubeinrichtung. Die Hubeinrichtung ist zur Erzeugung einer den ersten Rahmenkonstruktionsabschnitt in eine Bewegung, d. h. eine Hebe- oder Senkbewegung, relativ zu dem zweiten Rahmenkonstruktionsabschnitt versetzenden Hubkraft eingerichtet.

Die Rahmenkonstruktion umfasst eine Aufnahmeeinrichtung Die Aufnahmeeinrichtung umfasst einen Aufnahmeraum bzw. ein Aufnahmevolumen. Der Aufnahmeraum ist zur Aufnahme wenigstens eines Pulvermoduls innerhalb der Rahmenkonstruktion eingerichtet. Die Abmessungen des Aufnahmeraums sind demnach so gewählt, dass der Aufnahmeraum zur (vollständigen) Aufnahme wenigstens eines Pulvermoduls eingerichtet ist. Die Aufnahmeeinrichtung, d. h. insbesondere der Aufnahmeraum, ist typischerweise in dem ersten Rahmenkonstruktionsabschnitt angeordnet oder ausgebildet.

Die Hubeinrichtung ist insbesondere eingerichtet, den ersten Rahmenkonstruktionsabschnitt wenigstens zwischen einer Transportposition, in welcher eine Übergabe eines Pulvermoduls von dem Transportwagen in eine Arbeitsstation, oder umgekehrt, nicht möglich ist, und einer Übergabeposition, in welcher eine Übergabe eines Pulvermoduls von dem Transportwagen in eine Arbeitsstation möglich ist, zu bewegen. Bei der Transport- bzw. der Übergabeposition handelt es sich typischerweise um bestimmte vertikale Positionen des ersten Rahmenkonstruktionsabschnitts relativ zu dem zweiten Rahmenkonstruktionsabschnitt. Die Übergabeposition stellt typischerweise eine, insbesondere im Vergleich zu der Transportposition, obere Position des ersten Rahmenkonstruktionsabschnitts dar. Die Transportposition stellt typischerweise eine, insbesondere im Vergleich zu der Übergabeposition, untere Position des ersten Rahmenkonstruktionsabschnitts dar. Die bewegbare Lagerung des ersten Rahmenkonstruktionsabschnitts relativ zu dem zweiten Rahmenkonstruktionsabschnitt ermöglicht die Realisierung unterschiedlicher (vertikaler) Positionen des ersten Rahmenkonstruktionsabschnitts, welche typischerweise mit einer Verlagerung des Schwerpunkts des Transportwagens einhergehen, welche sich positiv auf die Bewegungs- bzw. Fahreigenschaften des Transportwagens auswirken. Durch den in der Transportposition vergleichsweise tiefen Schwerpunkt des Transportwagens ist die mögliche Gefahr eines Verkippens des Transportwagens ausgeschlossen bzw. reduziert.

Der Transportwagen ist in eine Vorandockposition bewegbar. In der Vorandockposition ist der Transportwagen mit einem bestimmten Abstand, d. h. insbesondere einem Abstand in einem Bereich zwischen 5 und 15 cm, beabstandet von einer arbeitsstationseitigen Gehäusekonstruktion angeordnet. Die Vorandockposition kann als Vorstufe für eine spätere Andockposition, in welcher der Transportwagen tatsächlich an eine arbeitsstationseitige Gehäusekonstruktion andockt, erachtet werden; in der Vorandockposition ist eine Übergabe eines Pulvermoduls von einem Transportwagen in eine Arbeitsstation, oder umgekehrt, typischerweise nicht möglich bzw. nicht vorgesehen.

Die Anlage kann eine erste Sicherungseinrichtung umfassen. Die erste Sicherungseinrichtung ist zur Sicherung eines in die Vorandockposition bewegten Transportwagens in der Vorandockposition eingerichtet. Die erste Sicherungseinrichtung ist sonach zur Sicherung der Position eines in die Vorandockposition bewegten Transportwagens relativ zu der arbeitsstationseitigen Gehäusekonstruktion eingerichtet.

Die erste Sicherungseinrichtung kann wenigstens ein arbeitsstationseitiges erstes Sicherungselement und wenigstens ein korrespondierendes transportwagenseitiges Gegensicherungselement umfassen. Das arbeitsstationseitige, d. h. an der Arbeitsstation angeordnete oder ausgebildete, erste Sicherungselement ist eingerichtet, mit einem transportwagenseitigen, d. h. an dem Transportwagen angeordneten oder ausgebildeten, Gegensicherungselement derart zusammenzuwirken, dass die Position des in die Vorandockposition bewegten Transportwagens relativ zu der arbeitsstationseitigen Gehäusekonstruktion gesichert ist, mithin der Transportwagen nicht aus der Vorandockposition bewegt werden kann. Das arbeitsstationseitige Sicherungselement und das transportwagenseitige Gegensicherungselement können in der Sicherungsstellung formschlüssig zusammenwirken. Das arbeitsstationseitige Sicherungselement kann demnach als Formschlusselement, d. h. z. B. als, insbesondere hakenartiger bzw. -förmiger, Vorsprung, ausgebildet sein oder einen solchen umfassen. Das transportwagenseitige Gegensicherungselement kann als korrespondierendes Gegenformschlusselement, d. h. z. B. als, insbesondere nutartige bzw. -förmige, Aufnahme für den Vorsprung, ausgebildet sein oder eine solche umfassen.

Das arbeitsstationseitige Sicherungselement kann zwischen einer Sicherungsstellung, in welcher es derart relativ zu einem transportwagenseitigen Gegensicherungselement bewegt ist, dass es mit diesem unter Ausbildung einer Sicherung der Vorandockposition des Transportwagens zusammenwirkt, und einer Nichtsicherungsstellung, in welcher es derart relativ zu einem transportwagenseitigen Gegensicherungselement bewegt ist, dass es nicht mit diesem unter Ausbildung einer Sicherung der Andockposition des Transportwagens zusammenwirkt, bewegbar gelagert sein. Die bewegbare Lagerung des Sicherungselements kann durch eine Stelleinrichtung realisiert sein. Die Stelleinrichtung kann wenigstens ein mit dem Sicherungselement (bewegungs)gekoppeltes Stellelement umfassen. Die Stelleinrichtung kann z. B. als eine einen bewegbar gelagerten Stellkolben umfassende Kolben-Zylinder-Einrichtung ausgebildet sein oder eine solche umfassen.

Alternativ oder ergänzend kann (auch) ein transportwagenseitiges Gegensicherungselement zwischen einer Sicherungsstellung, in welcher es derart relativ zu einem arbeitsstationseitigen Sicherungselement bewegt ist, dass es mit diesem unter Ausbildung einer Sicherung der Vorandockposition des Transportwagens zusammenwirkt, und einer Nichtsicherungsstellung, in welcher es derart relativ zu einem arbeitsstationseitigen Sicherungselement bewegt ist, dass es nicht mit diesem unter Ausbildung einer Sicherung der Andockposition des Transportwagens zusammenwirkt, bewegbar gelagert sein. Auch die bewegbare Lagerung des Gegensicherungselements kann durch eine Stelleinrichtung realisiert sein. Die Stelleinrichtung kann wenigstens ein mit dem Gegensicherungselement (bewegungs)gekoppeltes Stellelement umfassen. Die Stelleinrichtung kann z. B. als Schwenkeinrichtung, welche zur Verschwenkung des Gegensicherungselements zwischen der Sicherungs- und der Nichtsicherungsstellung eingerichtet ist, ausgebildet sein oder eine solche umfassen.

Die Anlage kann eine erste Erfassungseinrichtung umfassen. Die erste Erfassungseinrichtung ist zur Erfassung eines in die Vorandockposition bewegten Transportwagens und zur Erzeugung einer einen in die Vorandockposition bewegten Transportwagen beschreibenden Vorandockpositionsinformation eingerichtet. Alternativ oder ergänzend ist die erste Erfassungseinrichtung zur Erfassung einer vermittels der ersten Sicherungseinrichtung realisierten Sicherung eines in die Vorandockposition bewegten Transportwagens und zur Erzeugung einer eine vermittels der ersten Sicherungseinrichtung realisierte Sicherung eines in die Vorandockposition bewegten Transportwagens beschreibenden ersten Sicherungsinformation eingerichtet. Die erste Erfassungseinrichtung kann wenigstens ein, z. B. akustisches, elektrisches, optisches oder haptisches, Erfassungselement umfassen, welches auf Grundlage, z. B. akustischer, elektrischer, optischer oder haptischer, Signale Rückschlüsse auf die Positionierung und/oder Sicherung eines Transportwagens in der Vorandockposition ziehen kann. Konkrete Beispiele für ein Erfassungselement sind eine (akustische oder optische) Schranke oder ein (elektrischer und/oder mechanischer) Kontakt. Jeweilige Erfassungselemente können arbeitsstationseitig und/oder transportwagenseitig angeordnet oder ausgebildet sein. Unabhängig von ihrer konkreten Ausführungsform lässt sich über die erste Erfassungseinrichtung erfassen, ob ein Transportwagen in die Vorandockposition bewegt ist und/oder ob ein in die Vorandockposition bewegter Transportwagen in der Vorandockposition gesichert ist. Das jeweilige Erfassungsergebnis wird über die Vorandockpositionsinformation bzw. über die Sicherungsinformation abgebildet.

Die transportwagenseitige Hubeinrichtung kann eingerichtet sein, eine den ersten Rahmenkonstruktionsabschnitt, insbesondere ausgehend von der Transportposition, in eine Bewegung relativ zu dem zweiten Rahmenkonstruktionsabschnitt versetzende Hubkraft auf Grundlage einer Vorandockpositionsinformation und/oder auf Grundlage einer Sicherungsinformation zu erzeugen. Insbesondere kann die Hubeinrichtung, insbesondere ausgehend von der Transportposition, eingerichtet sein, den ersten Rahmenkonstruktionsabschnitt dann, wenn ein Transportwagen in die Vorandockposition bewegt ist und/oder wenn ein in die Vorandockposition bewegter Transportwagen in der Vorandockposition gesichert ist, in eine Bewegung in Richtung einer weiter unten beschriebenen Vorübergabeposition bzw. in Richtung der Übergabeposition zu versetzen. Derart kann insbesondere die Sicherheit der Anlage verbessert werden.

Der Transportwagen kann eine der transportwagenseitigen Hubeinrichtung zugeordnete Hubfreigabeeinrichtung umfassen. Die Hubfreigabeeinrichtung ist eingerichtet, auf Grundlage eines über eine, insbesondere transportwagenseitige, Benutzerschnittstelle benutzerseitig, z. B. durch eine haptische Eingabe, erzeugten Freigabebefehls eine Freigabeinformation zu erzeugen. Die Hubfreigabeeinrichtung kann entsprechend eine benutzerseitig betätigbare bzw. betätigende Betätigungsschnittstelle, d. h. z. B. einen Taster, Knopf, Touchscreen, etc. umfassen. Die Hubeinrichtung kann eingerichtet sein, die den ersten Rahmenkonstruktionsabschnitt relativ zu dem zweiten Rahmenkonstruktionsabschnitt versetzende Hubkraft auf Grundlage einer seitens der Hubfreigabeeinrichtung erzeugten Freigabeinformation zu erzeugen. Mithin kann, bevor eine tatsächliche Bewegung des ersten Rahmenkonstruktionsabschnitts erfolgt, eine Benutzerfreigabe erforderlich sein. Derart kann die Sicherheit der Anlage weiter verbessert werden.

Es wurde erwähnt, dass die transportwagenseitige Hubeinrichtung insbesondere eingerichtet ist, den ersten Rahmenkonstruktionsabschnitt zwischen einer Transportposition und einer Übergabeposition zu bewegen. Die Hubeinrichtung kann ferner eingerichtet sein, den ersten Rahmenkonstruktionsabschnitt, insbesondere ausgehend von der Transportposition des ersten Rahmenkonstruktionsabschnitts und der Vorandockposition des Transportwagens, in eine oberhalb der Übergabeposition liegende Vorübergabeposition zu bewegen. Die Vorübergabeposition kann (in vertikaler Richtung) einige cm, d. h. z. B. zwischen 5 und 15 cm, oberhalb der Übergabeposition liegen. Die Vorübergabeposition kann als Vorstufe für eine Übergabeposition, in welcher, wie erwähnt, eine Übergabe eines Pulvermoduls von dem Transportwagen in die Arbeitsstation, oder umgekehrt, möglich ist, erachtet werden; in der Vorübergabeposition ist eine Übergabe eines Pulvermoduls von einem Transportwagen in eine Arbeitsstation, oder umgekehrt, typischerweise noch nicht möglich bzw. nicht vorgesehen.

Die Anlage kann eine zweite Erfassungseinrichtung umfassen. Die zweite Erfassungseinrichtung ist zur Erfassung eines in die Vorübergabeposition bewegten ersten Rahmenkonstruktionsabschnitts und zur Erzeugung einer einen in die Vorübergabeposition bewegten ersten Rahmenkonstruktionsabschnitt beschreibenden Vorübergabepositionsinformation eingerichtet. Die zweite Erfassungseinrichtung kann wenigstens ein, z. B. akustisches, elektrisches, optisches oder haptisches, Erfassungselement umfassen, welches auf Grundlage, z. B. akustischer, elektrischer, optischer oder haptischer, Signale Rückschlüsse auf die Positionierung eines ersten Rahmenkonstruktionsabschnitts in der Vorübergabeposition ziehen kann. Konkrete Beispiele für ein Erfassungselement sind wiederum eine (akustische oder optische) Schranke oder ein (elektrischer und/oder mechanischer) Kontakt. Jeweilige Erfassungselemente können wiederum arbeitsstationseitig und/oder transportwagenseitig angeordnet oder ausgebildet sein. Unabhängig von ihrer konkreten Ausführungsform lässt sich über die zweite Erfassungseinrichtung erfassen, ob ein erster Rahmenkonstruktionsabschnitt in die Vorübergabeposition bewegt ist. Das jeweilige Erfassungsergebnis wird über die Vorübergabepositionsinformation abgebildet.

Es wurde erwähnt, dass der Transportwagen, insbesondere ausgehend von der Vorandockposition, auch in eine Andockposition bewegbar ist. Bei der Vorandock- und der Andockposition handelt es sich typischerweise um bestimmte horizontale (laterale) Positionen des Transportwagens relativ zu einer arbeitsstationseitigen Gehäusekonstruktion. In der Andockposition ist der Transportwagen mit einem im Vergleich zu der Vorandockposition geringeren Abstand beabstandet von einer jeweiligen arbeitsstationseitigen Gehäusekonstruktion oder unmittelbar anliegend an einer jeweiligen arbeitsstationseitigen Gehäusekonstruktion angeordnet. Der Transportwagen ist in der Andockposition derart an die arbeitsstationseitige Gehäusekonstruktion angedockt, dass eine Übergabe eines Pulvermoduls von dem Transportwagen in die Arbeitsstation, oder umgekehrt, möglich ist. In der Andockposition ist damit eine Übergabe eines Pulvermoduls von einem Transportwagen in eine Arbeitsstation, oder umgekehrt, möglich bzw. vorgesehen.

Bewegungen des Transportwagens von der Vorandockposition in die Andockposition setzen selbstverständlich eine Aufhebung einer etwaigen vermittels der ersten Sicherungseinrichtung realisierten Sicherung des Transportwagens in der Vorandockposition voraus. Grundsätzlich kann eine Bewegung des Transportwagens in die Andockposition manuell oder (teil)automatisiert erfolgen. In letzterem Fall kann z. B. die erste Sicherungseinrichtung verwendet werden, den Transportwagen ausgehend von der Vorandockposition in die Andockposition zu bewegen. Dies kann dadurch realisiert sein, dass durch das Zusammenwirken und eine Bewegung der arbeitsstationseitigen Sicherungselemente und der transportwagenseitigen Gegensicherungselemente relativ zueinander eine den Transportwagen von der Vorandockposition in die Andockposition bewegende Kraft, typischerweise eine Zugkraft, erzeugt wird. Die Kraft kann konkret durch eine den Transportwagen in die Andockposition bewegende Bewegung des mit dem transportwagenseitige Gegensicherungselement zusammenwirkenden, d. h. insbesondere gekoppelten, arbeitsstationseitigen Sicherungselements realisiert sein.

Die transportwagenseitige Hubeinrichtung kann eingerichtet sein, den ersten Rahmenkonstruktionsabschnitt, insbesondere ausgehend von der Vorübergabeposition, in die Übergabeposition auf Grundlage einer Vorübergabepositionsinformation zu bewegen (abzusenken). Insbesondere kann die Hubeinrichtung eingerichtet sein, den ersten Rahmenkonstruktionsabschnitt dann, wenn der Transportwagen in die Andockposition bewegt ist, insbesondere ausgehend von der Vorübergabeposition, in eine Bewegung in Richtung der Übergabeposition zu versetzen. Derart kann wiederum insbesondere die Sicherheit der Anlage verbessert werden.

Die Anlage kann ferner eine zweite Sicherungseinrichtung umfassen. Die zweite Sicherungseinrichtung ist zur Sicherung eines in die Übergabeposition bewegten ersten Rahmenkonstruktionsabschnitts eines Transportwagens in der Übergabeposition eingerichtet. Die zweite Sicherungseinrichtung ist sonach zur Sicherung der Position eines in die Übergabeposition bewegten ersten Rahmenkonstruktionsabschnitts, insbesondere relativ zu der arbeitsstationseitigen Gehäusekonstruktion, eingerichtet.

Die zweite Sicherungseinrichtung kann wenigstens ein arbeitsstationseitiges erstes Sicherungselement und wenigstens ein korrespondierendes transportwagenseitiges Gegensicherungselement umfassen. Das arbeitsstationseitige, d. h. an der Arbeitsstation angeordnete oder ausgebildete, erste Sicherungselement ist eingerichtet, mit einem transportwagenseitigen, d. h. an dem Transportwagen angeordneten oder ausgebildeten, Gegensicherungselement derart zusammenzuwirken, dass die Position des in die Übergabeposition bewegten ersten Rahmenkonstruktionsabschnitts relativ zu der arbeitsstationseitigen Gehäusekonstruktion gesichert ist, mithin der erste Rahmenkonstruktionsabschnitt (ohne Betätigung der Hubeinrichtung) nicht aus der Übergabeposition bewegt werden kann.

Das arbeitsstationseitige Sicherungselement und das transportwagenseitige Gegensicherungselement können in der Übergabeposition formschlüssig zusammenwirken. Das arbeitsstationseitige Sicherungselement kann demnach als Formschlusselement, d. h. z. B. als, insbesondere kegel- oder konusartiger bzw. - förmiger, Vorsprung, ausgebildet sein oder einen solchen umfassen. Das transportwagenseitige Gegensicherungselement kann als korrespondierendes Gegenformschlusselement, d. h. z. B. als, insbesondere kegel- oder konusartige bzw. - förmige, Aufnahme bzw. Buchse, ausgebildet sein oder eine solche umfassen. Ein entsprechendes Formschlusselement, insbesondere in Form eines kegel- oder konusartigen bzw. -förmigen Vorsprungs, kann aufgrund seiner geometrisch-konstruktiven Gestalt eine Zentrierfunktion etwa im Sinne eines Zentrierbolzens ausüben. Durch das Zusammenwirken eines Formschluss- und eines Gegenformschlusselements kann sonach eine Zentrierung des ersten Rahmenkonstruktionsabschnitts bzw. des gesamten Transportwagens relativ zu einer arbeitsstationseitigen Gehäusekonstruktion und somit eine Sicherung der Position des ersten Rahmenkonstruktionsabschnitts bzw. des gesamten Transportwagens in wenigstens zwei, insbesondere drei, orthogonal zueinander ausgerichteten Raumrichtungen realisiert werden.

Es wurde mehrfach erwähnt, dass in der Übergabeposition eine Übergabe eines Pulvermoduls von dem Transportwagen in eine Arbeitsstation, oder umgekehrt, möglich ist. Die transportwagenseitige Rahmenkonstruktion kann hierfür wenigstens eine Übergabeschnittstelle, insbesondere in Form einer Öffnung, umfassen, welche eine Übergabe eines Pulvermoduls aus der Aufnahmeeinrichtung in eine Arbeitsstation oder eine Übergabe eines Pulvermoduls aus einer Arbeitsstation in eine transportwagenseitige Aufnahmeeinrichtung ermöglicht. In analoger Weise kann eine arbeitsstationsseitige Gehäusekonstruktion wenigstens eine Übergabeschnittstelle, insbesondere in Form einer Öffnung, umfassen, welche eine Übergabe eines Pulvermoduls aus einer Arbeitsstation in eine transportwagenseitige Aufnahmeeinrichtung oder eine Übergabe eines Pulvermoduls aus einer transportwagenseitigen Aufnahmeeinrichtung in eine Arbeitsstation ermöglicht. In der Übergabeposition eines ersten Rahmenkonstruktionsabschnitts eines jeweiligen Transportwagens fluchtet die transportwagenseitige Übergabeschnittstelle typischerweise mit einer arbeitsstationsseitigen Übergabeschnittstelle, sodass eine Übergabe eines Pulvermoduls von dem Transportwagen in die Arbeitsstation, oder umgekehrt, ermöglicht ist.

Um eine vereinfachte, weil standardisierte Übergabe von Pulvermodulen zwischen den der Anlage zugehörigen Transportwagen und den der Anlage zugehörigen Arbeitsstationen innerhalb der Anlage zu ermöglichen, können jeweilige arbeitsstationsseitige und jeweilige transportwagenseitige Übergabeschnittstellen für alle der Anlage zugehörigen Arbeitsstationen und Transportwagen geometrisch-konstruktiv gleich, d. h. standardisiert, ausgeführt sein.

Jeweilige transportwagenseitige und jeweilige arbeitsstationseitige Übergabeschnittstellen können über eine Verschlusseinrichtung verschließbar sein. Die Verschlusseinrichtung kann ein Verschlusselement umfassen, welches zwischen einer Offenstellung, in welcher die jeweilige Übergabeschnittstelle zur Übergabe eines Pulvermoduls freigegeben ist, und einer Schließstellung, in welcher die jeweilige Übergabeschnittstelle zur Übergabe eines Pulvermoduls nicht freigegeben ist, bewegbar gelagert sein. Ein Bewegen des Verschlusselements in die Offen- bzw. in die Schließstellung, oder umgekehrt, kann automatisiert, z. B. in Abhängigkeit der Erfassung der Übergabeposition, d. h. in Abhängigkeit der Erfassung eines in die Übergabeposition bewegten ersten Rahmenkonstruktionsabschnitts, erfolgen. Eine Erfassung der Übergabeposition bzw. die Erfassung eines in die Übergabeposition bewegten ersten Rahmenkonstruktionsabschnitts kann über die zweite Erfassungseinrichtung oder über eine dritte Erfassungseinrichtung erfolgen. Die dritte Erfassungseinrichtung kann analog der zweiten Erfassungseinrichtung eingerichtet sein, sodass auf die diesbezüglichen Ausführungen verwiesen wird.

Die transportwagenseitige Aufnahmeeinrichtung kann eine Lagerungseinrichtung umfassen, welche zur, insbesondere hängenden, Lagerung wenigstens eines Pulvermoduls in dem Aufnahmeraum eingerichtet ist. Die Lagerungseinrichtung kann eingerichtet sein, ein Pulvermodul, insbesondere zwischen einer vollständig in dem Aufnahmeraum bzw. der Rahmenkonstruktion aufgenommenen ersten Position (Pulvermodullagerposition) und einer teilweise aus dem Aufnahmeraum bzw. der Rahmenkonstruktion herausragenden zweiten Position (Pulvermodulübergabeposition), bewegbar relativ zu dem ersten Rahmenkonstruktionsabschnitt zu lagern. Hierfür kann die Lagerungseinrichtung mehrere Lagerelemente, welche eine bewegbare Lagerung eines in dem Aufnahmeraum aufgenommenen Pulvermoduls relativ zu dem ersten Rahmenkonstruktionsabschnitt ermöglichen, umfassen. Bei entsprechenden Lagerelementen kann es sich z. B. um Gleit- oder Rollenlagerelemente handeln, welche unter Ausbildung einer bewegbaren Lagerung mit einem Pulvermodul zusammenwirken, d. h. z. B. in hierfür pulvermodulseitig vorgesehene, z. B. durch pulvermodulseitig vorhandene Ausnehmungen gebildete, Wirkabschnitte eingreifen.

Eine entsprechende Lagerungseinrichtung kann eine Pulvermodulsicherungseinrichtung umfassen. Die Pulvermodulsicherungseinrichtung ist zur Sicherung der Position eines in dem Aufnahmeraum aufgenommenen Pulvermoduls eingerichtet. Die Pulvermodulsicherungseinrichtung kann wenigstens ein rahmenkonstruktionsseitiges Sicherungselement umfassen, welches eingerichtet ist, mit einem pulvermodulseitigen Gegensicherungselement derart zusammenzuwirken, dass die Positionierung des in dem Aufnahmeraum aufgenommenen Pulvermoduls gesichert ist. Ein entsprechendes Sicherungselement kann zwischen einer Sicherungsstellung, in welcher es derart relativ zu einem pulvermodulseitigen Gegensicherungselement bewegt ist, dass es mit diesem unter Ausbildung einer Sicherung der Position eines Pulvermoduls zusammenwirkt, und einer Nichtsicherungsstellung, in welcher es derart relativ zu einem pulvermodulseitigen Gegensicherungselement bewegt ist, dass es nicht mit diesem unter Ausbildung einer Sicherung der Position eines Pulvermoduls zusammenwirkt, bewegbar sein.

Das rahmenkonstruktionsseitige Sicherungselement kann mit einem jeweiligen pulvermodulseitigen Gegensicherungselement in der Transportposition des ersten Rahmenkonstruktionsabschnitts zusammenwirken. Die Transportposition entspricht damit einer Sicherungsposition, in welcher die Position eines Pulvermoduls gegenüber unerwünschten Positionsänderungen gesichert ist. Dies kann derart realisiert sein, dass das pulvermodulseitige Gegensicherungselement in der Transportposition derart relativ zu dem rahmenkonstruktionsseitigen Sicherungselement bewegt ist, dass diese unter Ausbildung einer Sicherung des in dem Aufnahmeraum aufgenommenen Pulvermoduls zusammenwirken.

Das rahmenkonstruktionsseitige Sicherungselement und das pulvermodulseitige Gegensicherungselement können formschlüssig zusammenwirken. Das Sicherungselement kann als Formschlusselement, d. h. z. B. als, insbesondere bolzenartiger bzw. -förmiger, Vorsprung, ausgebildet sein oder ein solches umfassen und das Gegensicherungselement kann als korrespondierendes Gegenformschlusselement, d. h. z. B. als, insbesondere buchsenartige bzw. -förmige, Aufnahme für den Vorsprung, ausgebildet sein oder eine solche umfassen.

In zu der transportwagenseitigen Aufnahmeeinrichtung analoger Weise können auch jeweilige Arbeitsstationen eine entsprechende Lagerungseinrichtung umfassen. Die Lagerungseinrichtung kann eingerichtet sein, ein Pulvermodul entlang einer sich durch die Arbeitsstation erstreckenden Transportbahn bewegbar relativ zu der Gehäusekonstruktion zu lagern, wofür die Lagerungseinrichtung Lagerelemente, welche eine bewegbare Lagerung eines in der Lagerungseinrichtung angeordneten Pulvermoduls relativ zu der arbeitsstationseitigen Gehäusekonstruktion ermöglichen, umfasst. Bei entsprechenden Lagerelementen kann es sich wiederum z. B. um Gleit- oder Rollenlagerelemente handeln, welche unter Ausbildung einer bewegbaren Lagerung mit einem Pulvermodul zusammenwirken, d. h. z. B. in hierfür pulvermodulseitig vorgesehene, z. B. durch pulvermodulseitig vorhandene Ausnehmungen gebildete, Wirkabschnitte eingreifen.

Jeweilige transportwagenseitige und jeweilige arbeitsstationseitige Lagerungseinrichtungen fluchten in der Übergabeposition eines ersten Rahmenkonstruktionsabschnitts eines jeweiligen Transportwagens zweckmäßig miteinander, sodass sich eine sich zwischen Transportwagen und Arbeitsstation erstreckende durchgehende Transportbahn ergibt, welche es ermöglicht, dass in jeweiligen Lagerungseinrichtungen gelagerte Pulvermodule problemlos von einem Transportwagen in eine Arbeitsstation, und umgekehrt, übergebbar sind. Mit dem gleichen Zweck sind jeweilige transportwagenseitige Lagerungseinrichtungen und jeweilige arbeitsstationseitige Lagerungseinrichtungen zweckmäßig gleich bzw. standardisiert ausgebildet.

Die Erfindung betrifft neben der Anlage auch einen Transportwagen für eine entsprechende Anlage. Der Transportwagen zeichnet sich dadurch aus, dass er eine Rahmenkonstruktion umfasst, welche eine Aufnahmeeinrichtung umfasst, welche einen zur Aufnahme eines Pulvermoduls innerhalb der Rahmenkonstruktion eingerichteten Aufnahmeraum umfasst, wobei die Rahmenkonstruktion wenigstens zwei Rahmenkonstruktionsabschnitte umfasst, wobei ein erster Rahmenkonstruktionsabschnitt bewegbar relativ zu einem zweiten Rahmenkonstruktionsabschnitt, insbesondere in einer vertikal ausgerichteten Bewegungsrichtung, gelagert ist, wobei der Transportwagen wenigstens eine, insbesondere motorische, Hubeinrichtung umfasst, welche zur Erzeugung einer den ersten Rahmenkonstruktionsabschnitt in eine Bewegung relativ zu dem zweiten Rahmenkonstruktionsabschnitt versetzenden Hubkraft eingerichtet ist. Sämtliche Ausführungen im Zusammenhang mit der Anlage gelten analog für den Transportwagen.

Die Erfindung ist anhand von Ausführungsbeispielen in den Zeichnungsfiguren näher erläutert. Dabei zeigen:

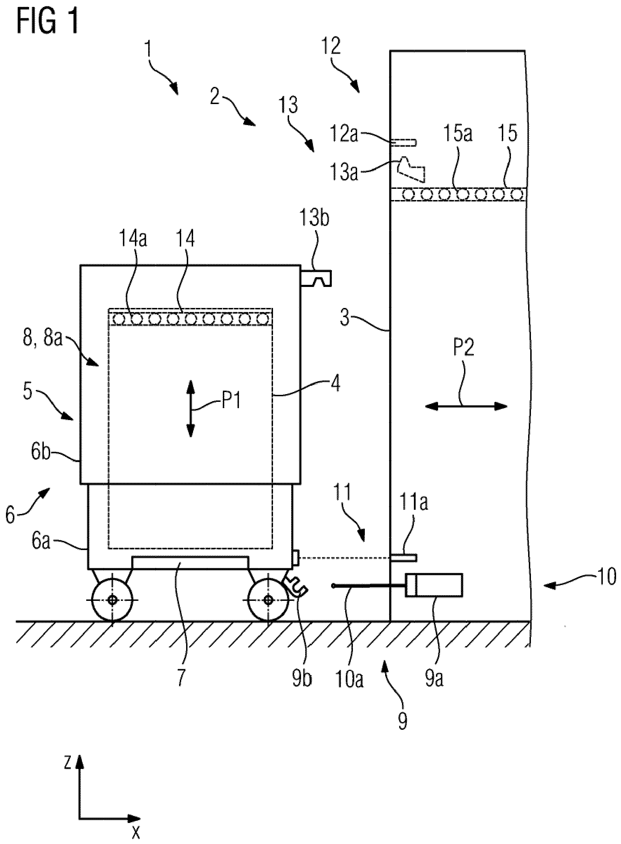

- Fig. 1 - 3: je eine Prinzipdarstellung eines Ausschnitts einer Anlage zur additiven Herstellung dreidimensionaler Objekte gemäß einem Ausführungsbeispiel.

Die Fig. 1 - 3 zeigen je eine Prinzipdarstellung eines Ausschnitts einer Anlage 1 zur additiven Herstellung dreidimensionaler Objekte gemäß einem Ausführungsbeispiel.

Die Anlage 1 umfasst, wenngleich in den Fig. jeweils nur eine einzige Arbeitsstation 2 gezeigt ist, typischerweise mehrere Arbeitsstationen 2, d. h. z. B. zur Durchführung additiver Arbeitsvorgänge eingerichtete Prozesstationen, welche als Vorrichtung (nicht näher bezeichnet) zur additiven Herstellung dreidimensionaler Objekte ausgebildet sind oder eine solche umfassen. Eine entsprechende Vorrichtung umfasst die zur Durchführung additiver Bauvorgänge erforderlichen Funktionskomponenten. Hierzu zählen insbesondere eine Beschichtungseinrichtung (nicht gezeigt), welche zur Ausbildung selektiv zu verfestigender Baumaterialschichten eingerichtet ist, und eine Belichtungseinrichtung (nicht gezeigt), welche zur selektiven Belichtung selektiv zu verfestigender Baumaterialschichten eingerichtet ist.

Andere Arbeitsstationen 2 können zur Durchführung nachbereitender Arbeitsvorgänge eingerichtete, auch als Nachbearbeitungsstation zu bezeichnende Arbeitsstationen 2 oder zur Durchführung vorbereitender Arbeitsvorgänge eingerichtete, auch als Vorbereitungsstationen zu bezeichnende Arbeitsstationen 2 sein.

Unabhängig von ihrer konkreten funktionellen Ausführung umfassen jeweilige Arbeitsstationen 2 eine eigene Gehäusekonstruktion 3, an oder in welcher die Funktionskomponenten der jeweiligen Arbeitsstation 2 angeordnet oder ausgebildet sind. Die Arbeitsstationen 2 sind als gesonderte, durch jeweilige Gehäusekonstruktionen 3 räumlich-körperlich definierte Funktionseinheiten der Anlage 1 zu sehen, welche in diversen Konfigurationen relativ zueinander, z. B. in einem oder mehreren Gebäude(abschnitte)n, insbesondere Fabrikhallen, positionierbar sind.

Die Anlage 1 umfasst eine Mehrzahl an im Rahmen der additiven Herstellung dreidimensionaler Objekte verwendeter Pulvermodule 4. Ein jeweiliges Pulvermodul 4 ist zur Aufnahme und/oder Abgabe von Baumaterial eingerichtet und umfasst hierfür typischerweise eine Pulverkammer (nicht gezeigt). Die Pulverkammer begrenzt einen mit Baumaterial befüllbaren Pulverraum. Der Pulverraum ist zumindest seitlich durch Wandungen (Pulverkammerwandungen) der Pulverkammer begrenzt. Bodenseitig kann der Pulverraum durch eine Trägereinrichtung (nicht gezeigt) begrenzt sein. Die Trägereinrichtung kann zwischen zwei Endstellungen, d. h. zwischen einer (bezogen auf die Höhe des Pulvermoduls 4) oberen und einer unteren Endstellung, relativ zu der Pulverkammer bewegbar gelagert sein. Die bewegbare Lagerung der Trägereinrichtung ermöglicht die Realisierung einer, insbesondere linearen, Bewegung der Trägereinrichtung entlang einer vertikalen Bewegungsachse bzw. in einer vertikalen Bewegungsrichtung. Die bewegbare Lagerung der Trägereinrichtung kann durch eine mit dieser gekoppelte, insbesondere (elektro)motorische, Antriebs- und/oder Aktoreinrichtung realisiert sein.

Konkret kann es sich bei einem Pulvermodul 4 um ein Baumodul, um ein Dosiermodul oder um ein Auffang- bzw. Überlaufmodul handeln.

Die Anlage 1 umfasst weiter eine Anzahl an Transportwagen 5. Ein jeweiliger Transportwagen 5 ist benutzerseitig, d. h. durch aktives Bewegen durch einen Benutzer, und/oder (teil)automatisiert über eine integrierte, insbesondere (elektro)motorische, Antriebseinrichtung (nicht gezeigt) zwischen den Arbeitsstation 2 der Anlage 1 bewegbar bzw. verfahrbar.

Der Transportwagen 5 umfasst eine Rahmenkonstruktion 6. Die Rahmenkonstruktion 6 umfasst zwei Rahmenkonstruktionsabschnitte 6a, 6b. Ein erster Rahmenkonstruktionsabschnitt 6a ist in einer durch den Doppelpfeil P1 angedeuteten vertikal ausgerichteten Bewegungsachse bzw. -richtung relativ zu einem zweiten Rahmenkonstruktionsabschnitt 6b bewegbar gelagert. Ersichtlich ist der erste Rahmenkonstruktionsabschnitt 6a oberhalb des zweiten Rahmenkonstruktionsabschnitts 6b angeordnet. Zur Realisierung von Bewegungen des ersten Rahmenkonstruktionsabschnitts 6a relativ zu dem zweiten Rahmenkonstruktionsabschnitt 6b umfasst der Transportwagen 5 eine, insbesondere (elektro)motorische, rein schematisch angedeutete Hubeinrichtung 7. Die Hubeinrichtung 7 ist zur Erzeugung einer den ersten Rahmenkonstruktionsabschnitt 6a in eine Bewegung, d. h. eine Hebe- oder Senkbewegung, relativ zu dem zweiten Rahmenkonstruktionsabschnitt 6b versetzenden Hubkraft eingerichtet.

Die Rahmenkonstruktion 6 umfasst eine in dem ersten Rahmenkonstruktionsabschnitt 6a angeordnete Aufnahmeeinrichtung 8. Die Aufnahmeeinrichtung 8 umfasst einen Aufnahmeraum 8a, welcher zur Aufnahme wenigstens eines Pulvermoduls 4 innerhalb der Rahmenkonstruktion 6 eingerichtet ist. Die Abmessungen des Aufnahmeraums 8a sind so gewählt, dass der Aufnahmeraum 8a zur (vollständigen) Aufnahme wenigstens eines Pulvermoduls 4 eingerichtet ist.

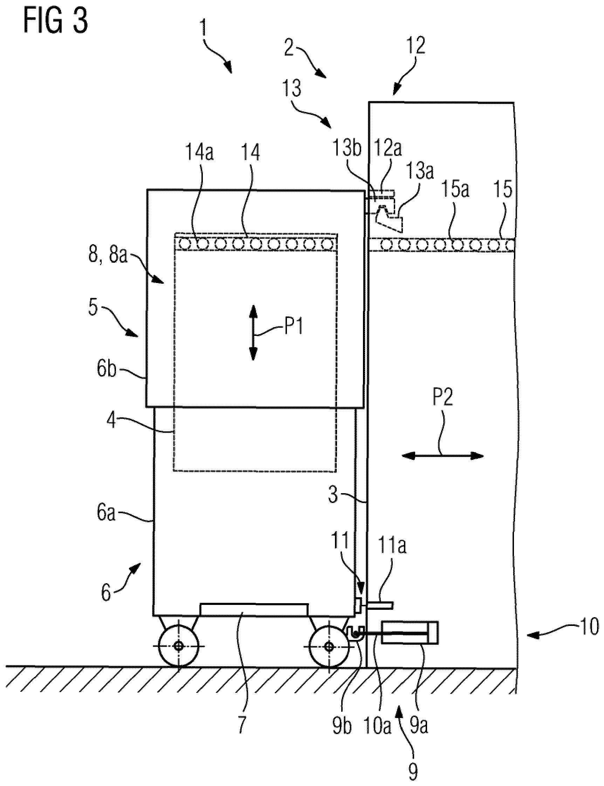

Die Hubeinrichtung 7 ist eingerichtet, den ersten Rahmenkonstruktionsabschnitt 6a wenigstens zwischen einer in Fig. 1 gezeigten Transportposition, in welcher eine Übergabe eines Pulvermoduls 4 von dem Transportwagen 5 in eine Arbeitsstation 2, oder umgekehrt, nicht möglich ist, und einer in Fig. 3 gezeigten Übergabeposition, in welcher eine Übergabe eines Pulvermoduls 4 von dem Transportwagen 5 in eine Arbeitsstation 2 möglich ist, zu bewegen. Die Übergabeposition stellt eine, insbesondere im Vergleich zu der Transportposition, obere Position des ersten Rahmenkonstruktionsabschnitts 6a dar. Die Transportposition stellt typischerweise eine, insbesondere im Vergleich zu der Übergabeposition, untere Position des ersten Rahmenkonstruktionsabschnitts 6a relativ zu dem zweiten Rahmenkonstruktionsabschnitt 6b dar. Mithin handelt es sich bei der Transport- bzw. der Übergabeposition um bestimmte vertikale Positionen des ersten Rahmenkonstruktionsabschnitts 6a.

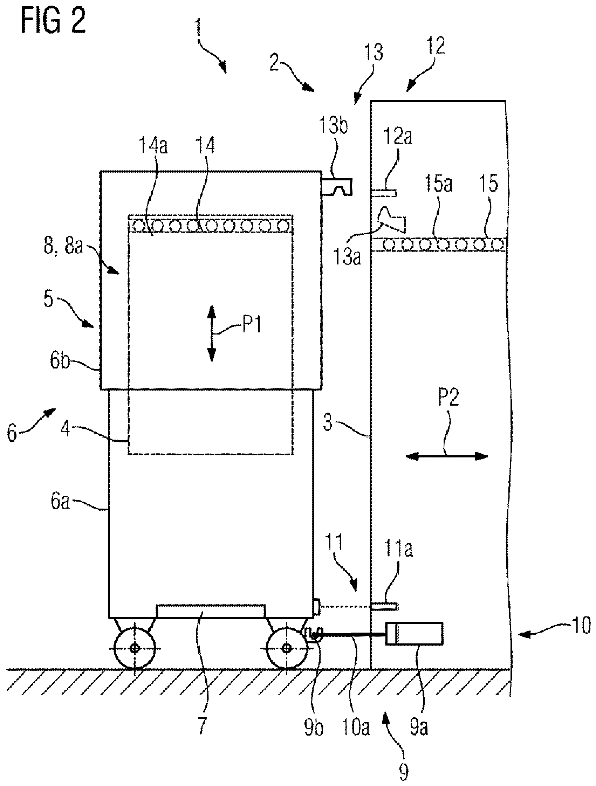

Der Transportwagen 5 ist in eine in Fig. 2 gezeigte Vorandockposition bewegbar. In der Vorandockposition ist der Transportwagen 5 mit einem bestimmten Abstand, d. h. insbesondere einem Abstand in einem Bereich zwischen 5 und 15 cm, beabstandet von der arbeitsstationsseitigen Gehäusekonstruktion 3 angeordnet. Die Vorandockposition kann als Vorstufe für eine Andockposition, in welcher der Transportwagen 5 an die arbeitsstationsseitige Gehäusekonstruktion 3 andockt, erachtet werden; in der Vorandockposition ist eine Übergabe eines Pulvermoduls 4 von dem Transportwagen 5 in die Arbeitsstation 2, oder umgekehrt, nicht möglich bzw. nicht vorgesehen.

Die Anlage 1 umfasst eine erste Sicherungseinrichtung 9, welche zur Sicherung des in die Vorandockposition bewegten Transportwagens 5 in der Vorandockposition eingerichtet ist. Die erste Sicherungseinrichtung 9 umfasst wenigstens ein arbeitsstationsseitiges erstes Sicherungselement 9a und wenigstens ein korrespondierendes transportwagenseitiges Gegensicherungselement 9b. Ein jeweiliges arbeitsstationsseitiges, d. h. an der Arbeitsstation 2 angeordnetes oder ausgebildetes, erstes Sicherungselement 9a ist eingerichtet, mit einem jeweiligen transportwagenseitigen, d. h. an dem Transportwagen 5 angeordneten oder ausgebildeten, Gegensicherungselement 9b derart zusammenzuwirken, dass die Position des in die Vorandockposition bewegten Transportwagens 5 relativ zu der arbeitsstationsseitigen Gehäusekonstruktion 3 gesichert ist. Das arbeitsstationsseitige Sicherungselement 9a und das transportwagenseitige Gegensicherungselement 9b wirken in der Sicherungsstellung formschlüssig zusammen. Das arbeitsstationsseitige Sicherungselement 9a ist als Formschlusselement, d. h. z. B. als, insbesondere hakenartiger bzw. -förmiger, Vorsprung, ausgebildet, das transportwagenseitige Gegensicherungselement 9b ist als korrespondierendes Gegenformschlusselement, d. h. z. B. als, insbesondere nutartige bzw. -förmige, Aufnahme für den Vorsprung, ausgebildet.

Anhand eines Vergleichs der Fig. 1 - 3 ist ersichtlich, dass das arbeitsstationseitige Sicherungselement 9a zwischen einer in Fig. 2 gezeigten Sicherungsstellung, in welcher es derart relativ zu dem transportwagenseitigen Gegensicherungselement 9b bewegt ist, dass es mit diesem unter Ausbildung einer Sicherung der Vorandockposition des Transportwagens 5 zusammenwirkt, und einer in Fig. 1 gezeigten Nichtsicherungsstellung, in welcher es derart relativ zu dem transportwagenseitigen Gegensicherungselement 9b bewegt ist, dass es nicht mit diesem unter Ausbildung einer Sicherung der Andockposition des Transportwagens 5 zusammenwirkt, bewegbar gelagert ist. Die bewegbare Lagerung des Sicherungselements 9a ist durch eine Stelleinrichtung 10 realisiert, welche ein mit dem Sicherungselement 9a (bewegungs)gekoppeltes Stellelement 10a umfasst. Die Stelleinrichtung 10 ist in den in den Fig. gezeigten Ausführungsbeispielen als eine einen bewegbar gelagerten Stellkolben umfassende Kolben-Zylinder-Einrichtung ausgebildet.

Auch das transportwagenseitige Gegensicherungselement 9b ist zwischen einer in Fig. 2 gezeigten Sicherungsstellung, in welcher es derart relativ zu dem arbeitsstationseitigen Sicherungselement 9a bewegt ist, dass es mit diesem unter Ausbildung einer Sicherung der Vorandockposition des Transportwagens 5 zusammenwirkt, und einer in Fig. 1 gezeigten Nichtsicherungsstellung, in welcher es derart relativ zu dem arbeitsstationseitigen Sicherungselement 9a bewegt ist, dass es nicht mit diesem unter Ausbildung einer Sicherung der Andockposition des Transportwagens 5 zusammenwirkt, bewegbar gelagert. Die bewegbare Lagerung des Gegensicherungselements 9b ist durch eine Stelleinrichtung (nicht nähre gezeigt) realisiert, welche ein mit dem Gegensicherungselement 9b (bewegungs)gekoppeltes Stellelement umfasst. Die Stelleinrichtung ist in den in den Fig. gezeigten Ausführungsbeispielen als Schwenkeinrichtung, welche zur Verschwenkung des Gegensicherungselements 9b zwischen der Sicherungs- und der Nichtsicherungsstellung eingerichtet ist, ausgebildet.

Die Anlage 1 umfasst eine erste Erfassungseinrichtung 11, welche zur Erfassung eines in die Vorandockposition bewegten Transportwagens 5 und zur Erzeugung einer einen in die Vorandockposition bewegten Transportwagen 5 beschreibenden Vorandockpositionsinformation und/oder zur Erfassung einer vermittels der ersten Sicherungseinrichtung 9 realisierten Sicherung eines in die Vorandockposition bewegten Transportwagens 5 und zur Erzeugung einer eine vermittels der ersten Sicherungseinrichtung 9 realisierte Sicherung eines in die Vorandockposition bewegten Transportwagens 5 beschreibenden ersten Sicherungsinformation eingerichtet ist. Die erste Erfassungseinrichtung 11 umfasst wenigstens ein, z. B. akustisches, elektrisches, optisches oder haptisches, Erfassungselement 11a, welches auf Grundlage, z. B. akustischer, elektrischer, optischer oder haptischer, Signale Rückschlüsse auf die Positionierung und/oder Sicherung eines Transportwagens 5 in der Vorandockposition ziehen kann. Konkret kann das Erfassungselement 11a z. B. als (akustische oder optische) Schranke oder als (elektrischer und/oder mechanischer) Kontakt ausgebildet. Entsprechende Erfassungselemente 11a können arbeitsstationseitig und/oder transportwagenseitig angeordnet oder ausgebildet sein.

Die transportwagenseitige Hubeinrichtung 7 ist eingerichtet, eine den ersten Rahmenkonstruktionsabschnitt 6a, insbesondere ausgehend von der Transportposition, in eine Bewegung relativ zu dem zweiten Rahmenkonstruktionsabschnitt 6b versetzende Hubkraft auf Grundlage einer Vorandockpositionsinformation und/oder auf Grundlage einer Sicherungsinformation zu erzeugen. Im Besonderen ist die Hubeinrichtung, insbesondere ausgehend von der Transportposition, eingerichtet, den ersten Rahmenkonstruktionsabschnitt 6a dann, wenn der Transportwagen 5 in die Vorandockposition bewegt ist und/oder wenn der in die Vorandockposition bewegte Transportwagen 5 in der Vorandockposition gesichert ist, in eine Bewegung in Richtung der Übergabeposition zu versetzen.

Der Transportwagen 5 kann eine der transportwagenseitigen Hubeinrichtung 7 zugeordnete Hubfreigabeeinrichtung (nicht gezeigt) umfassen. Die Hubfreigabeeinrichtung ist eingerichtet, auf Grundlage eines über eine, insbesondere transportwagenseitige, Benutzerschnittstelle (nicht gezeigt) benutzerseitig, z. B. durch eine haptische Eingabe, erzeugten Freigabebefehls eine Freigabeinformation zu erzeugen. Die Hubfreigabeeinrichtung kann entsprechend eine benutzerseitig betätigbare bzw. betätigende Betätigungsschnittstelle, d. h. z. B. einen Taster, Knopf, Touchscreen, etc. umfassen. Die Hubeinrichtung 7 kann eingerichtet sein, die den ersten Rahmenkonstruktionsabschnitt 6a relativ zu dem zweiten Rahmenkonstruktionsabschnitt 6b versetzende Hubkraft auf Grundlage einer seitens der Hubfreigabeeinrichtung erzeugten Freigabeinformation zu erzeugen. Mithin kann, bevor eine tatsächliche Bewegung des ersten Rahmenkonstruktionsabschnitts 6a erfolgt, eine Benutzerfreigabe erforderlich sein.

Die Hubeinrichtung 7 ist, wie sich aus Fig. 2 ergibt, ferner eingerichtet, den ersten Rahmenkonstruktionsabschnitt 6a, insbesondere ausgehend von der Transportposition des ersten Rahmenkonstruktionsabschnitts 6a und der Vorandockposition des Transportwagens 5, in eine in Fig. 2 gezeigte oberhalb der in Fig. 3 gezeigten Übergabeposition liegende Vorübergabeposition zu bewegen. Die Vorübergabeposition liegt (in vertikaler Richtung) einige cm, d. h. z. B. zwischen 5 und 15 cm, oberhalb der Übergabeposition. Die Vorübergabeposition kann als Vorstufe für die Übergabeposition, in welcher, wie erwähnt, eine Übergabe eines Pulvermoduls 4 von dem Transportwagen 5 in die Arbeitsstation 2, oder umgekehrt, möglich ist, erachtet werden; in der Vorübergabeposition ist eine Übergabe eines Pulvermoduls 4 von dem Transportwagen 5 in die Arbeitsstation 2, oder umgekehrt, typischerweise noch nicht möglich bzw. nicht vorgesehen.

Die Anlage 1 umfasst ferner eine zweite Erfassungseinrichtung 12, welche zur Erfassung eines in die Vorübergabeposition bewegten ersten Rahmenkonstruktionsabschnitts 6a und zur Erzeugung einer einen in die Vorübergabeposition bewegten ersten Rahmenkonstruktionsabschnitt 6a beschreibenden Vorübergabepositionsinformation eingerichtet ist. Die zweite Erfassungseinrichtung 12 umfasst wenigstens ein, z. B. akustisches, elektrisches, optisches oder haptisches, Erfassungselement 12a, welches auf Grundlage, z. B. akustischer, elektrischer, optischer oder haptischer, Signale Rückschlüsse auf die Positionierung des ersten Rahmenkonstruktionsabschnitts 6a in der Vorübergabeposition ziehen kann. Konkret kann das Erfassungselement 12a wiederum z. B. als (akustische oder optische) Schranke oder als (elektrischer und/oder mechanischer) Kontakt ausgebildet sein. Entsprechende Erfassungselemente 12a können wiederum arbeitsstationseitig und/oder transportwagenseitig angeordnet oder ausgebildet sein.

Anhand der Fig. ist ersichtlich, dass es sich bei der Vorandockposition (Fig. 2) und der Andockposition (Fig. 3) um bestimmte horizontale (laterale) Positionen des Transportwagens 5 relativ zu der arbeitsstationseitigen Gehäusekonstruktion3 handelt. Aus einem Vergleich der Fig. 2, 3 ergibt sich, dass der Transportwagen 5 in der Andockposition mit einem im Vergleich zu der Vorandockposition geringeren Abstand beabstandet von der arbeitsstationseitigen Gehäusekonstruktion 3 bzw. unmittelbar anliegend an der arbeitsstationseitigen Gehäusekonstruktion 3 angeordnet ist. Der Transportwagen 5 ist in der Andockposition derart an die arbeitsstationseitige Gehäusekonstruktion 3 angedockt, dass eine Übergabe eines Pulvermoduls 4 von dem Transportwagen 5 in die Arbeitsstation 2, oder umgekehrt, möglich ist.

Selbstverständlich setzen Bewegungen des Transportwagens 5 von der Vorandockposition in die Andockposition eine Aufhebung einer etwaigen vermittels der ersten Sicherungseinrichtung 9 realisierten Sicherung des Transportwagens 5 in der Vorandockposition voraus. Grundsätzlich kann eine Bewegung des Transportwagens 5 in die Andockposition manuell oder (teil)automatisiert erfolgen. In letzterem Fall kann z. B. die erste Sicherungseinrichtung 9 verwendet werden, den Transportwagen 5 ausgehend von der Vorandockposition in die Andockposition zu bewegen. Dies kann dadurch realisiert sein, dass durch das Zusammenwirken und eine Bewegung der arbeitsstationseitigen Sicherungselemente 9a und der transportwagenseitigen Gegensicherungselemente 9b relativ zueinander eine den Transportwagen 5 in die Andockposition bewegende Kraft, typischerweise eine Zugkraft, erzeugt wird. Die Kraft kann konkret durch eine den Transportwagen 5 in die Andockposition bewegende Bewegung des mit dem transportwagenseitige Gegensicherungselement 9b zusammenwirkenden, d. h. insbesondere gekoppelten, arbeitsstationseitigen Sicherungselements 9a realisiert sein.

Die transportwagenseitige Hubeinrichtung 7 ist eingerichtet, den ersten Rahmenkonstruktionsabschnitt 6a, insbesondere ausgehend von der Vorübergabeposition, in die Übergabeposition auf Grundlage einer Vorübergabepositionsinformation zu bewegen (abzusenken). Im Besonderen ist die Hubeinrichtung 7 eingerichtet, den ersten Rahmenkonstruktionsabschnitt 6a dann, wenn der Transportwagen 5 in die Andockposition bewegt ist, insbesondere ausgehend von der Vorübergabeposition, in eine Bewegung in Richtung der Übergabeposition zu versetzen.

Die Anlage 1 umfasst ferner eine zweite Sicherungseinrichtung 13, welche zur Sicherung des in die Übergabeposition bewegten ersten Rahmenkonstruktionsabschnitts 6a in der Übergabeposition eingerichtet ist. Die zweite Sicherungseinrichtung 13 umfasst wenigstens ein arbeitsstationseitiges erstes Sicherungselement 13a und wenigstens ein korrespondierendes transportwagenseitiges Gegensicherungselement 13b. Ein jeweiliges arbeitsstationseitiges, d. h. an der Arbeitsstation 2 angeordnetes oder ausgebildetes, erstes Sicherungselement 13a ist eingerichtet, mit einem jeweiligen transportwagenseitigen, d. h. an dem Transportwagen 5 angeordneten oder ausgebildeten, Gegensicherungselement 13b derart zusammenzuwirken, dass die Position des in die Übergabeposition bewegten ersten Rahmenkonstruktionsabschnitts 6a relativ zu der arbeitsstationseitigen Gehäusekonstruktion 3 gesichert ist, mithin der erste Rahmenkonstruktionsabschnitt 6a (ohne Betätigung der Hubeinrichtung 7) nicht aus der Übergabeposition bewegt werden kann.

Jeweilige arbeitsstationseitige Sicherungselemente 13a und jeweilige transportwagenseitige Gegensicherungselemente 13b wirken in der Übergabeposition formschlüssig zusammen. Jeweilige arbeitsstationseitige Sicherungselemente 13a sind als Formschlusselemente, d. h. als, insbesondere kegel- oder konusartige bzw. -förmige, Vorsprünge, ausgebildet. Jeweilige transportwagenseitige Gegensicherungselemente 13b sind als korrespondierende Gegenformschlusselemente, d. h. als, insbesondere kegeloder konusartige bzw. -förmige, Aufnahmen bzw. Buchsen, ausgebildet. Ein entsprechendes Formschlusselement, insbesondere in Form eines kegel- oder konusartigen bzw. -förmigen Vorsprungs, übt aufgrund seiner geometrisch-konstruktiven Gestalt eine Zentrierfunktion etwa im Sinne eines Zentrierbolzens aus. Durch das Zusammenwirken jeweiliger Formschluss- und jeweiliger Gegenformschlusselemente ist sonach eine Zentrierung des ersten Rahmenkonstruktionsabschnitts 6a bzw. des gesamten Transportwagens 5 relativ zu der arbeitsstationseitigen Gehäusekonstruktion 3 und somit eine Sicherung der Position des ersten Rahmenkonstruktionsabschnitts 6a bzw. des gesamten Transportwagens in wenigstens zwei, insbesondere drei, orthogonal zueinander ausgerichteten Raumachsen bzw. -richtungen, vgl. das eingetragene Koordinatensystem, realisiert.

Es wurde mehrfach erwähnt, dass in der Übergabeposition eine Übergabe eines Pulvermoduls 4 von dem Transportwagen 5 in die Arbeitsstation 2, oder umgekehrt, möglich ist. Die transportwagenseitige Rahmenkonstruktion 6 umfasst hierfür wenigstens eine Übergabeschnittstelle (nicht gezeigt), insbesondere in Form einer Öffnung, welche eine Übergabe eines Pulvermoduls 4 aus der transportwagenseitigen Aufnahmeeinrichtung 8 in eine Arbeitsstation 2 oder eine Übergabe eines Pulvermoduls 4 aus der Arbeitsstation 2 in die transportwagenseitige Aufnahmeeinrichtung 8 ermöglicht.

In analoger Weise umfasst die arbeitsstationsseitige Gehäusekonstruktion 3 wenigstens eine Übergabeschnittstelle (nicht gezeigt), insbesondere in Form einer Öffnung, welche eine Übergabe eines Pulvermoduls 4 aus der Arbeitsstation 2 in die transportwagenseitige Aufnahmeeinrichtung 8 oder eine Übergabe eines Pulvermoduls 4 aus der transportwagenseitigen Aufnahmeeinrichtung 8 in die Arbeitsstation 2 ermöglicht. Die die transportwagenseitige Übergabeschnittstelle fluchtet in der Übergabeposition mit der arbeitsstationsseitigen Übergabeschnittstelle, sodass eine Übergabe eines Pulvermoduls 4 von dem Transportwagen 5 in die Arbeitsstation 2, oder umgekehrt, ermöglicht ist.

Um eine vereinfachte, weil standardisierte Übergabe von Pulvermodulen 4 zwischen den der Anlage 1 zugehörigen Transportwagen 5 und den der Anlage 1 zugehörigen Arbeitsstationen 2 innerhalb der Anlage 1 zu ermöglichen, sind jeweilige arbeitsstationsseitige und jeweilige transportwagenseitige Übergabeschnittstellen für alle der Anlage 1 zugehörigen Arbeitsstationen 2 und Transportwagen 5 geometrisch-konstruktiv gleich, d. h. standardisiert, ausgeführt.

Jeweilige transportwagenseitige und jeweilige arbeitsstationseitige Übergabeschnittstellen können über eine Verschlusseinrichtung (nicht gezeigt) verschließbar sein. Eine entsprechende Verschlusseinrichtung kann ein Verschlusselement umfassen, welches zwischen einer Offenstellung, in welcher die jeweilige Übergabeschnittstelle zur Übergabe eines Pulvermoduls 4 freigegeben ist, und einer Schließstellung, in welcher die jeweilige Übergabeschnittstelle zur Übergabe eines Pulvermoduls 4 nicht freigegeben ist, bewegbar gelagert sein. Ein Bewegen des Verschlusselements in die Offen- bzw. in die Schließstellung, oder umgekehrt, kann automatisiert, z. B. in Abhängigkeit der Erfassung der Übergabeposition, d. h. in Abhängigkeit der Erfassung eines in die Übergabeposition bewegten ersten Rahmenkonstruktionsabschnitts 6a, erfolgen. Eine Erfassung der Übergabeposition bzw. die Erfassung eines in die Übergabeposition bewegten ersten Rahmenkonstruktionsabschnitts 6a kann über die zweite Erfassungseinrichtung 12 oder über eine dritte Erfassungseinrichtung (nicht gezeigt) erfolgen. Die dritte Erfassungseinrichtung kann analog der zweiten Erfassungseinrichtung 12 eingerichtet sein.

Anhand von Fig. 1 ist ersichtlich, dass die transportwagenseitige Aufnahmeeinrichtung 8 eine Lagerungseinrichtung 14 umfasst, welche zur, insbesondere hängenden, Lagerung wenigstens eines Pulvermoduls 4 in dem Aufnahmeraum 8a eingerichtet ist. Die Lagerungseinrichtung 14 ist eingerichtet, ein Pulvermodul 4, insbesondere zwischen einer vollständig in dem Aufnahmeraum 8a bzw. der Rahmenkonstruktion 6 aufgenommenen ersten Position (Pulvermodullagerposition) und einer teilweise aus dem Aufnahmeraum 8a bzw. der Rahmenkonstruktion 6 herausragenden zweiten Position (Pulvermodulübergabeposition), bewegbar zu lagern. Hierfür umfasst die Lagerungseinrichtung 14 mehrere Lagerelemente 14a, welche eine bewegbare Lagerung eines in dem Aufnahmeraum 8a aufgenommenen Pulvermoduls 4 ermöglichen. Bei den Lagerelementen 14a kann es sich z. B. um Gleit- oder Rollenlagerelemente handeln, welche unter Ausbildung einer bewegbaren Lagerung mit einem Pulvermodul 4 zusammenwirken, d. h. z. B. in hierfür pulvermodulseitig vorgesehene, z. B. durch pulvermodulseitig vorhandene Ausnehmungen gebildete, Wirkabschnitte (nicht gezeigt) eingreifen.

Eine entsprechende Lagerungseinrichtung 14 kann eine Pulvermodulsicherungseinrichtung (nicht gezeigt) umfassen. Die Pulvermodulsicherungseinrichtung ist zur Sicherung der Position eines in dem Aufnahmeraum 8a aufgenommenen Pulvermoduls 4 eingerichtet. Die Pulvermodulsicherungseinrichtung kann wenigstens ein rahmenkonstruktionsseitiges Sicherungselement umfassen, welches eingerichtet ist, mit einem pulvermodulseitigen Gegensicherungselement derart zusammenzuwirken, dass die Positionierung des in dem Aufnahmeraum 8a aufgenommenen Pulvermoduls 4 gesichert ist. Ein entsprechendes Sicherungselement kann zwischen einer Sicherungsstellung, in welcher es derart relativ zu einem pulvermodulseitigen Gegensicherungselement bewegt ist, dass es mit diesem unter Ausbildung einer Sicherung der Position eines Pulvermoduls 4 zusammenwirkt, und einer Nichtsicherungsstellung, in welcher es derart relativ zu einem pulvermodulseitigen Gegensicherungselement bewegt ist, dass es nicht mit diesem unter Ausbildung einer Sicherung der Position eines Pulvermoduls 4 zusammenwirkt, bewegbar sein.

Ein jeweiliges rahmenkonstruktionsseitige Sicherungselement kann mit einem jeweiligen pulvermodulseitigen Gegensicherungselement in der Transportposition des ersten Rahmenkonstruktionsabschnitts 6a zusammenwirken. Die Transportposition entspricht damit einer Sicherungsposition, in welcher die Position eines Pulvermoduls 4 gegenüber unerwünschten Positionsänderungen gesichert ist. Dies kann derart realisiert sein, dass das pulvermodulseitige Gegensicherungselement in der Transportposition derart relativ zu dem rahmenkonstruktionsseitigen Sicherungselement bewegt ist, dass diese unter Ausbildung einer Sicherung des in dem Aufnahmeraum 8a aufgenommenen Pulvermoduls 4 zusammenwirken.

Ein jeweiliges rahmenkonstruktionsseitiges Sicherungselement und ein jeweiliges pulvermodulseitiges Gegensicherungselement können formschlüssig zusammenwirken. Das Sicherungselement kann als Formschlusselement, d. h. z. B. als, insbesondere bolzenartiger bzw. -förmiger, Vorsprung, ausgebildet sein, und das Gegensicherungselement kann als korrespondierendes Gegenformschlusselement, d. h. z. B. als, insbesondere buchsenartige bzw. -förmige, Aufnahme für den Vorsprung, ausgebildet sein.

In zu der transportwagenseitigen Aufnahmeeinrichtung 8 analoger Weise kann auch die Arbeitsstation 2 eine entsprechende Lagerungseinrichtung 15 umfassen. Die Lagerungseinrichtung 15 ist eingerichtet sein, ein Pulvermodul 4 entlang einer durch den Doppelpfeil P2 angedeuteten, sich durch die Arbeitsstation 2 erstreckenden Transportbahn bewegbar relativ zu der Gehäusekonstruktion 3 zu lagern, wofür die Lagerungseinrichtung 15 Lagerelemente 15a, welche eine bewegbare Lagerung eines in der Lagerungseinrichtung 15 angeordneten Pulvermoduls 4 relativ zu der Gehäusekonstruktion 3 ermöglichen, umfasst. Bei entsprechenden Lagerelementen 15a kann es sich wiederum z. B. um Gleit- oder Rollenlagerelemente handeln, welche unter Ausbildung einer bewegbaren Lagerung mit einem Pulvermodul 4 zusammenwirken, d. h. z. B. in hierfür pulvermodulseitig vorgesehene, z. B. durch pulvermodulseitig vorhandene Ausnehmungen gebildete, Wirkabschnitte eingreifen.

Jeweilige transportwagenseitige und jeweilige arbeitsstationseitige Lagerungseinrichtungen 14, 15 fluchten in der Übergabeposition eines ersten Rahmenkonstruktionsabschnitts 6a miteinander, sodass sich eine sich zwischen Transportwagen 5 und Arbeitsstation 2 erstreckende durchgehende Transportbahn ergibt, welche es ermöglicht, dass in jeweiligen Lagerungseinrichtungen 14, 15 gelagerte Pulvermodule 4 problemlos von einem Transportwagen 5 in eine Arbeitsstation2 , und umgekehrt, übergebbar sind. Mit dem gleichen Zweck sind jeweilige transportwagenseitige Lagerungseinrichtungen 14 und jeweilige arbeitsstationseitige Lagerungseinrichtungen 15 gleich bzw. standardisiert ausgebildet.

Einzelne Merkmale der Erfindung sind ferner in den folgenden Aspekten aufgeführt:
1. Anlage (1) zur additiven Herstellung dreidimensionaler Objekte, umfassend wenigstens eine Arbeitsstation (2), welche zur Durchführung wenigstens eines Arbeitsvorgangs im Rahmen der additiven Herstellung dreidimensionaler Objekte eingerichtet ist, **gekennzeichnet durch**
   wenigstens einen, insbesondere benutzerseitig, bewegbaren, insbesondere verschiebbaren, Transportwagen (5), welcher eine Rahmenkonstruktion (6) umfasst, welche eine Aufnahmeeinrichtung (8) umfasst, welche einen zur Aufnahme eines Pulvermoduls (4) innerhalb der Rahmenkonstruktion (6) eingerichteten Aufnahmeraum (8a) umfasst, wobei
   die Rahmenkonstruktion (6) wenigstens zwei Rahmenkonstruktionsabschnitte (6a, 6b) umfasst, wobei ein erster Rahmenkonstruktionsabschnitt (6a) bewegbar relativ zu einem zweiten Rahmenkonstruktionsabschnitt (6b), insbesondere in einer vertikal ausgerichteten Bewegungsrichtung, gelagert ist, wobei
   der Transportwagen (5) wenigstens eine, insbesondere motorische, Hubeinrichtung (7) umfasst, welche zur Erzeugung einer den ersten Rahmenkonstruktionsabschnitt (6a) in eine Bewegung relativ zu dem zweiten Rahmenkonstruktionsabschnitt (6b) versetzenden Hubkraft eingerichtet ist.
2. Anlage nach Aspekt 1, **dadurch gekennzeichnet, dass** die transportwagenseitige Hubeinrichtung (7) eingerichtet ist, den ersten Rahmenkonstruktionsabschnitt (6a) wenigstens zwischen einer Transportposition, in welcher eine Übergabe eines Pulvermoduls (4) von dem Transportwagen (5) in eine Arbeitsstation (2), oder umgekehrt, nicht möglich ist, und einer Übergabeposition, in welcher eine Übergabe eines Pulvermoduls (4) von dem Transportwagen (5) in eine Arbeitsstation (2) möglich ist, zu bewegen.
3. Anlage nach einem der vorhergehenden Aspekte, **dadurch gekennzeichnet, dass** der Transportwagen (5) in eine Vorandockposition bewegbar ist, in welcher er mit einem bestimmten Abstand, insbesondere einem Abstand in einem Bereich zwischen 5 und 15 cm, beabstandet von einer arbeitsstationseitigen Gehäusekonstruktion (3) angeordnet ist.
4. Anlage nach Aspekt 3, **gekennzeichnet durch** eine erste Sicherungseinrichtung (9), welche zur Sicherung eines in die Vorandockposition bewegten Transportwagens (5) in der Vorandockposition eingerichtet ist.
5. Anlage nach Aspekt 3 oder 4, **gekennzeichnet durch** eine erste Erfassungseinrichtung (11), welche zur Erfassung eines in die Vorandockposition bewegten Transportwagens (5) eingerichtet ist und zur Erzeugung einer einen in die Vorandockposition bewegten Transportwagen (5) beschreibenden Vorandockpositionsinformation eingerichtet ist und/oder welche zur Erfassung einer vermittels der ersten Sicherungseinrichtung (9) realisierten Sicherung eines in die Vorandockposition bewegten Transportwagens (5) und zur Erzeugung einer eine vermittels der ersten Sicherungseinrichtung (9) realisierte Sicherung eines in die Vorandockposition bewegten Transportwagens (5) beschreibenden ersten Sicherungsinformation eingerichtet ist.
6. Anlage nach Aspekt 5, **dadurch gekennzeichnet, dass** die transportwagenseitige Hubeinrichtung (7) eingerichtet ist, eine den ersten Rahmenkonstruktionsabschnitt (6a), insbesondere ausgehend von der Transportposition, in eine Bewegung relativ zu dem zweiten Rahmenkonstruktionsabschnitt (6a) versetzenden Hubkraft auf Grundlage einer Vorandockpositionsinformation und/oder auf Grundlage einer Sicherungsinformation zu erzeugen.
7. Anlage nach einem der vorhergehenden Aspekte, **gekennzeichnet durch** eine der transportwagenseitigen Hubeinrichtung (7) zugeordnete Hubfreigabeeinrichtung, welche eingerichtet ist, auf Grundlage eines über eine, insbesondere transportwagenseitige, Benutzerschnittstelle benutzerseitig erzeugten Freigabebefehls eine Freigabeinformation zu erzeugen, wobei die transportwagenseitige Hubeinrichtung (7) eingerichtet ist, die einen jeweiligen ersten Rahmenkonstruktionsabschnitt (6a) relativ zu einem jeweiligen zweiten Rahmenkonstruktionsabschnitt (6b) versetzende Hubkraft auf Grundlage einer seitens der Hubfreigabeeinrichtung erzeugten Freigabeinformation zu erzeugen.
8. Anlage nach einem der Aspekte 2 bis 7, **dadurch gekennzeichnet, dass** die transportwagenseitige Hubeinrichtung (7) eingerichtet ist, den ersten Rahmenkonstruktionsabschnitt (6a), insbesondere ausgehend von der Transportposition des ersten Rahmenkonstruktionsabschnitts (6a) und einer Vorandockposition des Transportwagens (5), in eine oberhalb der Übergabeposition liegende Vorübergabeposition zu bewegen.
9. Anlage nach Aspekt 8, **gekennzeichnet durch** eine zweite Erfassungseinrichtung (12), welche zur Erfassung eines in die Vorübergabeposition bewegten ersten Rahmenkonstruktionsabschnitts (6a) und zur Erzeugung einer einen in die Vorübergabeposition bewegten ersten Rahmenkonstruktionsabschnitt (6a) beschreibenden Vorübergabepositionsinformation eingerichtet ist.
10. Anlage nach Aspekt 9, **dadurch gekennzeichnet, dass** der Transportwagen (5), insbesondere ausgehend von der Vorandockposition des Transportwagens (5) und der Vorübergabeposition des ersten Rahmenkonstruktionsabschnitts (6a), in eine Andockposition bewegbar ist, in welcher er mit einem im Vergleich zu der Vorandockposition geringeren Abstand beabstandet von der jeweiligen arbeitsstationseitigen Gehäusekonstruktion (3) oder unmittelbar anliegend an der jeweiligen arbeitsstationseitigen Gehäusekonstruktion (3) angeordnet ist.
11. Anlage nach Aspekt 9 oder 10, **dadurch gekennzeichnet, dass** die transportwagenseitige Hubeinrichtung (7) eingerichtet ist, den ersten Rahmenkonstruktionsabschnitt (6a), insbesondere ausgehend von der Vorübergabeposition, in eine jeweilige Übergabeposition auf Grundlage einer Vorübergabepositionsinformation zu bewegen.
12. Anlage nach einem der Aspekte 2 bis 11, **gekennzeichnet durch** eine zweite Sicherungseinrichtung (13), welche zur Sicherung eines in die Übergabeposition bewegten ersten Rahmenkonstruktionsabschnitts (6a) eines Transportwagens (5) in der Übergabeposition eingerichtet ist.
13. Anlage nach einem der vorhergehenden Aspekte, **dadurch gekennzeichnet, dass** die transportwagenseitige Rahmenkonstruktion (6) wenigstens eine Übergabeschnittstelle, insbesondere in Form einer Öffnung, umfasst, welche eine Übergabe eines Pulvermoduls (4) aus der Aufnahmeeinrichtung (8) in eine arbeitsstationseitige Gehäusekonstruktion (3) oder eine Übergabe eines Pulvermoduls (4) aus einer arbeitsstationseitigen Gehäusekonstruktion (3) in die Aufnahmeeinrichtung (8) ermöglicht, und
   eine arbeitsstationsseitige Gehäusekonstruktion (3) wenigstens eine Übergabeschnittstelle, insbesondere in Form einer Öffnung, umfasst, welche eine Übergabe eines Pulvermoduls (4) aus der arbeitsstationseitigen Gehäusekonstruktion (3) in eine transportwagenseitige Aufnahmeeinrichtung (8) oder eine Übergabe eines Pulvermoduls (4) aus einer transportwagenseitigen Aufnahmeeinrichtung (8) in die arbeitsstationseitige Gehäusekonstruktion (3) ermöglicht.
14. Anlage nach Aspekt 13, **dadurch gekennzeichnet, dass** die transportwagenseitige Übergabeschnittstelle mit der arbeitsstationsseitigen Übergabeschnittstelle in der Übergabeposition eines ersten Rahmenkonstruktionsabschnitts (6a) eines jeweiligen Transportwagens (5) fluchtet, sodass eine Übergabe eines Pulvermoduls (4) von dem Transportwagen (5) in die arbeitsstationseitige Gehäusekonstruktion (3), oder umgekehrt, ermöglicht ist.
15. Anlage nach Aspekt 13 oder 14, **dadurch gekennzeichnet, dass** jeweilige arbeitsstationsseitige und jeweilige transportwagenseitige Übergabeschnittstellen für alle der Anlage (1) zugehörigen Arbeitsstationen (2) und Transportwagen (5), insbesondere geometrisch-konstruktiv, gleich ausgeführt sind.
16. Anlage nach einem der Aspekte 13 bis 15, **gekennzeichnet durch** eine einer jeweiligen Übergabeschnittstelle zugeordnete Verschlusseinrichtung, wobei eine jeweilige Verschlusseinrichtung ein Verschlusselement umfasst, welches zwischen einer Offenstellung, in welcher die jeweilige Übergabeschnittstelle zur Übergabe eines Pulvermoduls (4) von dem jeweiligen Transportwagen (5) in eine jeweilige arbeitsstationseitige Gehäusekonstruktion (3), oder umgekehrt, freigegeben ist, und einer Schließstellung, in welcher die jeweilige Übergabeschnittstelle nicht zur Übergabe eines Pulvermoduls (4) von dem jeweiligen Transportwagen (5) in eine jeweilige arbeitsstationseitige Gehäusekonstruktion (3), oder umgekehrt, freigegeben ist, bewegbar gelagert ist.
17. Anlage nach einem der vorhergehenden Aspekte, **dadurch gekennzeichnet, dass** die transportwagenseitige Aufnahmeeinrichtung (8) eine Lagerungseinrichtung (14) umfasst, welche zur, insbesondere hängenden, Lagerung wenigstens eines Pulvermoduls (4) in dem Aufnahmeraum (8) eingerichtet ist, wobei die Lagerungseinrichtung (14) eingerichtet ist, ein Pulvermodul (4), insbesondere zwischen einer vollständig in dem Aufnahmeraum (8a) aufgenommenen ersten Position und einer teilweise aus dem Aufnahmeraum (8a) herausragenden zweiten Position, bewegbar relativ zu dem ersten Rahmenkonstruktionsabschnitt (6a) zu lagern.
18. Anlage nach Aspekt 17, **gekennzeichnet durch** eine der Lagerungseinrichtung (14) zugeordnete Pulvermodulsicherungseinrichtung, welche zur Sicherung der Position eines in dem Aufnahmeraum (8a) aufgenommenen Pulvermoduls (4) eingerichtet ist.
19. Anlage nach einem der vorhergehenden Aspekte, **dadurch gekennzeichnet, dass** eine jeweilige Arbeitsstation (2) eine Gehäusekonstruktion (3) mit einer Lagerungseinrichtung (15) umfasst, welche eingerichtet ist, ein Pulvermodul (4) entlang einer sich durch die Arbeitsstation (2) erstreckenden Transportbahn bewegbar relativ zu der Gehäusekonstruktion (3) zu lagern.
20. Transportwagen (5) für eine Anlage (1) nach einem der vorhergehenden Aspektee, **dadurch gekennzeichnet, dass** er eine Rahmenkonstruktion (6) umfasst, welche eine Aufnahmeeinrichtung (8) umfasst, welche einen zur Aufnahme eines Pulvermoduls (4) innerhalb der Rahmenkonstruktion (6) eingerichteten Aufnahmeraum (8a) umfasst, wobei
   die Rahmenkonstruktion (6) wenigstens zwei Rahmenkonstruktionsabschnitte (6a, 6b) umfasst, wobei ein erster Rahmenkonstruktionsabschnitt (6a) bewegbar relativ zu einem zweiten Rahmenkonstruktionsabschnitt (6b), insbesondere in einer vertikal ausgerichteten Bewegungsrichtung, gelagert ist, wobei
   der Transportwagen (5) wenigstens eine, insbesondere motorische, Hubeinrichtung (7) umfasst, welche zur Erzeugung einer den ersten Rahmenkonstruktionsabschnitt (6a) in eine Bewegung relativ zu dem zweiten Rahmenkonstruktionsabschnitt (6b) versetzenden Hubkraft eingerichtet ist.

## Patentansprüche

1. Anlage (1) zur additiven Herstellung dreidimensionaler Objekte, umfassend:
wenigstens einen, insbesondere benutzerseitig, bewegbaren, insbesondere verschiebbaren, Transportwagen (5);
wenigstens eine Arbeitsstation (2), welche zur Durchführung wenigstens eines Arbeitsvorgangs im Rahmen der additiven Herstellung dreidimensionaler Objekte eingerichtet ist, wobei die Arbeitsstation (2) eingerichtet ist, wenigstens einen Arbeitsvorgang durchzuführen, in welchem ein Pulvermodul (4) der Arbeitsstation (2) mittels eines Transportwagens (5) zugeführt wird, wobei der Transportwagen (5) umfasst:
eine Rahmenkonstruktion (6), welche einen ersten Rahmenkonstruktionsabschnitt (6a) und einen zweiten Rahmenkonstruktionsabschnitt (6b) umfasst, wobei der erste Rahmenkonstruktionsabschnitt (6a) vertikal relativ zu dem zweiten Rahmenkonstruktionsabschnitt (6a) bewegbar ist, wobei der erste Rahmenkonstruktionsabschnitt (6a) eine Aufnahmeeinrichtung (8) mit einem Aufnahmeraum (8a) zur Aufnahme eines Pulvermoduls (4) umfasst;
eine Hubeinrichtung (7), welche zur Bewegung des ersten Rahmenkonstruktionsabschnitts (6a) relativ zu dem zweiten Rahmenkonstruktionsabschnitt (6b) von einer Transportposition in eine Übergabeposition eingerichtet ist;
eine erste Sicherungseinrichtung (9), welche eingerichtet ist, mit der wenigstens einen Arbeitsstation (2) zusammenzuwirken, um den Transportwagen (5) in einer Andockposition (5) relativ zu der Arbeitsstation (2) zu sichern; und
eine zweite Sicherungseinrichtung (13), welche zur Sicherung des in die Übergabeposition bewegten ersten Rahmenkonstruktionsabschnitts (6a) in der Übergabeposition eingerichtet ist.

2. Anlage nach Anspruch 1, wobei der wenigstens eine Arbeitsvorgang umfasst: einen additiven Arbeitsvorgang, d. h. einen additiven Bauvorgang, in welchem ein additiver Aufbau eines Objekts erfolgt, und/oder einen vor einem additiven Arbeits- bzw. Bauvorgang durchzuführenden vorbereitenden Arbeitsvorgänge, und/oder einen nach einem additiven Arbeits- bzw. Bauvorgang durchzuführenden nachbereitenden Arbeitsvorgang.

3. Anlage nach Anspruch 1 oder 2, wobei die Arbeitsstation (2) eine Gehäusekonstruktion (3) und eine Lagerungseinrichtung (15) umfasst, wobei die Lagerungseinrichtung (15) eingerichtet ist, das Pulvermodul (4) relativ zu der Gehäusekonstruktion (3) entlang einer sich durch die Arbeitsstation (2) erstreckenden Transportbahn bewegbar zu lagern.

4. Anlage nach einem der vorhergehenden Ansprüche, wobei die Arbeitsstation (2) eine Gehäusekonstruktion (3) und eine Lagerungseinrichtung (15) umfasst, wobei die Lagerungseinrichtung (15) eingerichtet ist, das Pulvermodul (4) relativ zu der Gehäusekonstruktion (3) entlang einer sich durch die Arbeitsstation (2) erstreckenden Transportbahn bewegbar zu lagern; und wobei
der Transportwagen (5) eine eine Transportbahn bildende Lagerungseinrichtung (14) umfasst, wobei jeweilige transportwagenseitige und jeweilige arbeitsstationseitige Lagerungseinrichtungen (14, 15) in der Übergabeposition eines ersten Rahmenkonstruktionsabschnitts des Transportwagens (5) miteinander fluchten, sodass sich eine sich zwischen Transportwagen (5) und Arbeitsstation (2) erstreckende durchgehende Transportbahn ergibt.

5. Anlage nach Anspruch 3, wobei die Lagerungseinrichtung (14) des Transportwagens (5) eingerichtet ist, ein Pulvermodul (4) zwischen einer vollständig in dem Aufnahmeraum (8a) bzw. der Rahmenkonstruktion (6) aufgenommenen ersten Position und einer teilweise aus dem Aufnahmeraum (8a) bzw. der Rahmenkonstruktion (6) herausragenden zweiten Position bewegbar zu lagern.

6. Anlage nach einem der vorhergehenden Ansprüche, wobei die erste Sicherungseinrichtung (9) wenigstens ein erstes Sicherungselement umfasst, das eingerichtet ist, mit einem ersten Gegensicherungselement der wenigstens einen Arbeitsstation (2) zusammenzuwirken.

7. Anlage nach einem der vorhergehenden Ansprüche, wobei die zweite Sicherungseinrichtung wenigstens ein zweites Sicherungselement umfasst, das eingerichtet ist, mit einem zweiten Gegensicherungselement der wenigstens einen Arbeitsstation (2) zusammenzuwirken.
